(19) Europäisches Patentamt
European Patent Office
Office européen des brevets

(11) **EP 4 629 103 A1**

(12) **EUROPEAN PATENT APPLICATION**

(43) Date of publication:
**08.10.2025 Bulletin 2025/41**

(21) Application number: **25158108.8**

(22) Date of filing: **14.02.2025**

(51) International Patent Classification (IPC):
**G06F 16/901** (2019.01)    **G06F 17/10** (2006.01)
**G06N 20/00** (2019.01)    **H03M 7/30** (2006.01)

(52) Cooperative Patent Classification (CPC):
**G06F 16/9024; G06F 17/10; G06N 20/00; H03M 7/3059**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.03.2024 US 202463565748 P**
**08.08.2024 US 202418797907**

(71) Applicant: **INTEL Corporation**
**Santa Clara, CA 95054 (US)**

(72) Inventors:
• **AGUERREBERE OTEGUI, Maria Cecilia**
**Santa Clara, 95054 (US)**
• **BHATI, Ishwar Singh**
**Santa Clara, 95054 (US)**
• **HILDEBRAND, Mark**
**Santa Clara, 95054 (US)**
• **TEPPER, Mariano**
**Santa Clara, 95054 (US)**
• **WILLKE, Theodore**
**Santa Clara, 95054 (US)**

(74) Representative: **Rummler, Felix**
**Maucher Jenkins**
**Seventh Floor Offices**
**Artillery House**
**11-19 Artillery Row**
**London SW1P 1RT (GB)**

(54) **MULTI-MEANS LOCALLY-ADAPTIVE VECTOR QUANTIZATION FOR MEMORY EFFICIENT AND HIGH-PERFORMANCE STREAMING SIMILARITY SEARCH**

(57) Systems, apparatuses and methods may provide for technology that determines a plurality of means based on a plurality of vectors, wherein each mean in the plurality of means corresponds to center of a cluster, assigns each vector in a plurality of vectors to a mean in the plurality of means, and conducts a compression of the plurality of vectors based on the plurality of means. The technology may also build a directed graph based on the compressed plurality of vectors and update the directed graph. Updating the graph may involve determining a plurality of modified means, detecting that a change in one or more modified means in the plurality of modified means exceeds a threshold, conducting an update of the modified mean(s), and bypassing the update for one or more remaining means in the plurality of modified means.

**FIG. 1**

**Description**

## CROSS-REFERENCE TO RELATED APPLICATIONS

The present application claims the benefit of priority to U.S. Provisional Patent Application No. 63/565,748, filed on March 15, 2024.

## BACKGROUND

Streaming similarity searching is the process of retrieving - from a large collection of vectors that evolve over time - those vectors that are most similar to a given query vector at a given moment in time. Streaming similarity searching is a key component of countless classical real-world applications (e.g., recommender systems, advertisement matching, etc.) and in recent years the usages of streaming similarity searching have grown significantly with the rise of deep learning (DL) models that can translate semantic affinities into spatial similarities and consequently enable semantic searching. A prominent example is retrieval augmented generation (RAG), which extends the capabilities of generative artificial intelligence (AI) with more factually accurate, up-to-date, and verifiable results.

## BRIEF DESCRIPTION OF THE DRAWINGS

The various advantages of the embodiments will become apparent to one skilled in the art by reading the following specification and appended claims, and by referencing the following drawings, in which:

FIG. 1 is an illustration of an example of a retrieval augmented generation (RAG) workflow according to an embodiment;

FIG. 2 is a pseudo code listing of an example of a traversal of a directed graph according to an embodiment;

FIG. 3 is an illustration of an example of a multi-means locally-adaptive vector quantization (M-LVQ) definition according to an embodiment;

FIG. 4 is a flowchart of an example of a method of maintaining a directed graph according to an embodiment;

FIG. 5 is a flowchart of an example of a method of updating a directed graph over time according to an embodiment;

FIG. 6 is a block diagram of an example of a performance-enhanced computing system according to an embodiment;

FIG. 7 is an illustration of an example of a semiconductor package apparatus according to an embodiment;

FIG. 8 is a block diagram of an example of a processor according to an embodiment; and

FIG. 9 is a block diagram of an example of a multi-processor based computing system according to an embodiment.

## DETAILED DESCRIPTION

Retrieval augmented generation (RAG) is an artificial intelligence (AI) model retraining alternative that can create a domain-specific large language model (LLM) by augmenting open-source pre-trained models with both proprietary and open data. Accordingly, RAG develops business-specific results, while keeping data safe and secure (e.g., without sharing the data with third-party large foundation models). Indeed, RAG can be deployed in a wide range of industries such as, for example, consumer goods and retails, healthcare and medicine, manufacturing, media and entertainment, financial services, and so forth.

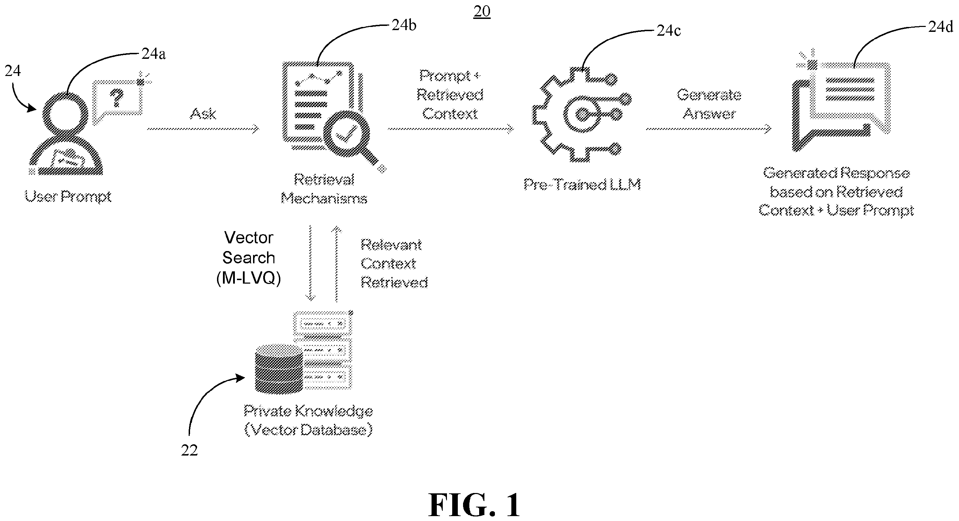

FIG. 1 shows an RAG workflow 20 in which private knowledge 22 (e.g., custom-built knowledge stored in a vector database) is added into a prompt stream 24 (24a-24d) of an AI model as dynamic, query-dependent data. In the illustrated example, a first stage 24a of the prompt stream 24 conducts user query processing, a second stage 24b of the prompt stream 24 retrieves relevant context data from the private knowledge 22, a third stage 24c incorporates the relevant data into the input of a pre-trained LLM (e.g., source model), and a fourth stage 24d outputs a generated response based on the retrieved context and the user prompt. The prompt and the retrieved context enrich the output of the pre-trained LLM, delivering more relevant and accurate results.

More particularly, the second stage 24b of the prompt stream 24 converts the user prompt into a vector embedding and uses vector searching to find similar content in the vector database of the private knowledge 22 (e.g., calculating the distance between the user prompt and the data retrieved from the vector database). The vector database can be pre-constructed from PDF (portable document format) files, logs, transcripts, and so forth. The most relevant data is retrieved, incorporated with the user prompt, and passed to the pre-trained model of the third stage 24c for inference service and final output generation. This context incorporation provides models with additional information unavailable during pretraining, better aligning the models with the task or domain of interest of the user. Because RAG may not require retraining or fine-tuning the model, RAG can be an efficient way to add the data of an organization to provide context to an LLM.

The amount of unstructured data in vector databases is constantly growing at an accelerated pace. Indeed, databases with billions of vectors, each with hundreds of dimensions, are becoming standard. Data-driven indices, among which graph-based approaches dominate, stand out by offering fast and highly-accurate searches for billions of high-dimensional vectors. Incrementally updating, however, the internal data structures of these databases to reflect the changes in the collection of vectors while keeping the vector search fast and accurate is still an open problem.

Therefore, techniques to perform fast and accurate streaming similarity search in these large dynamic vector databases with a small memory footprint are of significant importance. The technology described herein, multi-means locally-adaptive vector quantization (M-LVQ), reduces the memory footprint of the vector databases and improves search throughput (e.g., measured as queries per second/QPS) at high accuracy, while being suited to efficient incremental updates (e.g., to reflect changes in the collection of vectors over time).

Among the variety of similarity search algorithms, some can be naturally extended to the streaming case, whereas others may be adapted to this scenario. Nevertheless, these solutions struggle to simultaneously achieve both high-accuracy and high-performance for high-dimensional vectors. State-of-the-art graph-based methods are fast and highly accurate but at the cost of a large memory footprint, which is becoming untenable as vector databases grow in size. Some alternative techniques may use inverted indices with quantization for low memory footprint, but these techniques struggle to achieve high accuracy and high performance simultaneously. Locally-adaptive Vector Quantization (LVQ) is a highly efficient vector compression solution that yields state-of-the-art search performance for non-evolving databases. The search performance of LVQ, however, may be affected in streaming similarity search scenarios.

As will be discussed in greater detail, the technology described herein provides a simultaneously fast, highly accurate, and lightweight solution for the high accuracy and high performance streaming similarity search regime. The main principle of the technology described herein is to reduce the memory footprint of vector databases and, at the same time, improve graph-based streaming similarity search performance without sacrificing accuracy. Embodiments propose a vector compression scheme, M-LVQ, an extension of LVQ, which maintains the advantages of LVQ: a) nimble decoding and similarity search computations even with random access patterns common in graph-based search algorithms, b) ~4x compression, c) ~4x and ~8x reductions in the effective memory bandwidth, with respect to a float32-valued (32-bit floating point valued) vector, and d) high recall rates, and adds: a) flexibility to update the vector encoding over time as the collection of vectors evolves, and b) increased search performance through an improved compression accuracy. M-LVQ is particularly suited for streaming similarity search (e.g., for evolving data streams) but can also be used for static similarity search (e.g., for databases that do not change over time).

Streaming similarity search is at the core of countless real-world workloads, powering, for example, the capabilities of Generative Artificial Intelligence (AI) through RAG. The technology described herein conducts accurate and high performance streaming similarity searches for billion-scale vector databases possible at a much lower total cost of ownership (TCO). Furthermore, embodiments use performance optimizations (e.g., such as 512-bit Advance Vector Extensions/AVX512, prefetching, etc.) to implement the technology described herein. The technology described herein can be integrated as part of the Scalable Vector Search (SVS) similarity search library from INTEL.

In one example, the operations carried out on input datasets by the source code of the program/library improve distance computations in the search routine. Typically, after constructing the index, the size of the saved data is much smaller (4x-8x) than the original dataset. Additionally, the memory bandwidth associated with memory accesses is lower (up to 4-8x) than expected based on the dataset characteristics.

## Introduction

As already noted, similarity searching is the process of retrieving from a large collection of vectors those vectors that are most similar to a given query vector. Similarity searching is an integral component of countless classical real-world applications (e.g., recommender systems or advertisement/ad matching).

For many of these applications, data will change over time. For example, in the case of a generative AI powered system using RAG, the private knowledge 22 in the external knowledge repository is kept up-to-date to provide meaningful responses. This condition involves inserting new data and deleting outdated information, while keeping the vector searches fast and accurate. These updates bring streaming similarity searching into play. Streaming similarity searches attempt to maintain a dynamic data structure that enables the efficient and accurate retrieval of the approximate nearest neighbors of any query issued at a given time, among the database vectors that are active at that time. Depending on the application, the vectors in the data stream may be independent and identically distributed (IID) or may undergo a data distribution shift over time. For example, a retail company might incorporate new products over time, or seasonal trends causing content drift in social media sites.

In the streaming setting, an initial database $X_0 = \{x_i \in R^d\}$ $i = 1, ..., n_0$ may be provided containing $n_0$ vectors in $d$ dimensions. Then, at each time $t > 1$, a vector $x_i$ is either added or removed (e.g., $X_t = X_{t-1} \cup \{x_i\}$ or $X_t = X_{t-1} \setminus \{x_i\}$). It may be assumed, with no loss of generality, that each vector has a universally unique ID.

Given $X_t$, a symmetric similarity function $sim: R^d \times R^d \to R$ where a higher value indicates a higher degree of similarity, and a query $q \in R^d$, the similarity search (or nearest neighbor) problem involves finding the $k$ vectors in $X_t$ with maximum similarity to $q$. In most practical applications, accuracy is traded for performance to avoid a linear scan of $X_t$, by relaxing the definition to allow for a certain degree of error (e.g., a few of the retrieved elements, the approximate nearest neighbors/ANN) may not belong to the ground-truth top $k$ neighbors.

**Graph-based similarity search:** Graph-based methods provide fast and highly accurate similarity search and constitute the state-of-the-art in the *static* and *dynamic* cases. Graph-based similarity solutions build a proximity graph, connecting two nodes if nodes fulfill a defined neighborhood criterion with demonstrable properties, and use a "greedy" traversal to find the nearest neighbor.

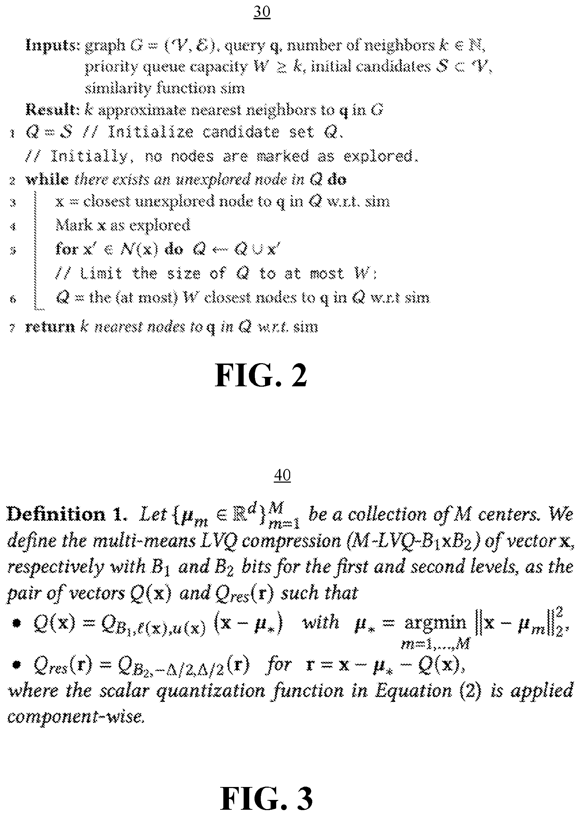

Turning now to FIG. 2, a pseudo code listing 30 demonstrates that a graph can be traversed using a modified greedy best-first approach to retrieve the $k$ approximate nearest vectors to query $q$ with respect to the similarity function *sim*. Graph construction involves building a navigable graph for $X_0$ and performing additions and deletions to update the graph over time.

**Locally-Adaptive Vector Quantization**

As already noted, LVQ is a compression technique that uses per-vector scaling and scalar quantization to boost search performance by enabling fast similarity computations and a reduced effective bandwidth, while decreasing memory footprint and hardly impacting accuracy.

Let $\mu = [\mu_1, \ldots, \mu_d]$ be the sample mean, $\mu = \frac{1}{n}\sum_{i=1}^{n} x_i$, and $u, l: R^d \rightarrow R$, defined for a vector $x = [x_1, \ldots, x_d]$, as

$$u(\mathbf{x}) = \max_j x_j - \mu_j, \qquad \ell(\mathbf{x}) = \min_j x_j - \mu_j. \qquad (1)$$

Let $Q_{B,l,u}: R \rightarrow R$ be the scalar quantization function,

$$Q_{B,\ell,u}(x) = \Delta \left\lfloor \frac{x-\ell}{\Delta} + \frac{1}{2} \right\rfloor + \ell, \quad \text{with} \quad \Delta = \frac{u-\ell}{2^B - 1}. \qquad (2)$$

In LVQ, the vector $x$ is represented by a vector $Q(x)$ and, optionally, by another vector $Q_{res}(r)$, obtained by:

- performing a first-level encoding of $x$ into $Q(x)$ with $B_1$ bits using

$$Q(\mathbf{x}) = Q_{B_1,\ell(\mathbf{x}),u(\mathbf{x})}(\mathbf{x} - \boldsymbol{\mu}), \qquad (3)$$

   by applying $Q_{B,l,u}$ component-wise; and
- optionally performing a second-level encoding of the residual vector $r = x - \mu - Q(x)$ into $Q_{res}(r)$, with $B_2$ bits by applying $Q_{B_2,-\Delta/2,\Delta/2}$ component-wise (the components of $r$ lie in $[-\Delta/2, \Delta/2]$).

The one-level and the two-level variants are denoted herein by LVQ-B and LVQ-B_1×B_2, respectively.

LVQ is particularly designed for graph-based similarity search, with a random memory access pattern. The first-level LVQ vectors are used during graph traversal, which improves the search performance by compressing the vectors into fewer bits and thus reducing the memory bandwidth effectively consumed. Any degradation in search accuracy caused by the scalar quantization errors can be regained by increasing the search window size W, at the cost of slowing down the search, and/or by using the second-level residuals to perform a final re-ranking.

**M-LVQ**

As already noted, M-LVQ maintains the advantages of LVQ: a) nimble decoding and similarity search computations even with random access patterns common in graph-based search algorithms, b) ~4x compression, c) ~4x and ~8x reductions in the effective memory bandwidth, with respect to a float32-valued vector, and d) high recall rates, and adds: a) flexibility to update the encoding over time as the collection of vectors evolves, and b) potentially better search performance through an improved compression accuracy.

LVQ characterizes the data distribution with a global mean. By contrast, M-LVQ improves accuracy by modeling the data distribution more tightly. In one example, a mixture model is used, where each vector is described with respect to a local mean.

Turning now to FIG. 3, an M-LVQ definition 40 demonstrates that the technology described herein augments LVQ with multiple means, which corresponds to a Gaussian mixture model with spherical components of equal variance.

In this setting, each vector is assigned to one of $M$ centers $\{\boldsymbol{\mu}_m\}_{m=1}^{M}$, which are computed using k-means. Eq. (3) can then be replaced with $Q_{B_1,l(x),u(x)}(\boldsymbol{x} - \boldsymbol{\mu}_*)$ where $\boldsymbol{\mu}_*$ is the closest center to $\boldsymbol{x}$, i.e., $\boldsymbol{\mu}_* = argmin_m \parallel \boldsymbol{x} - \boldsymbol{\mu}_m \parallel_2^2$. The original LVQ is therefore now a particular case where $M = 1$.

The main benefit of M-LVQ in the *static* case is the reduction of the quantization error. As $M$ increases, $\parallel \boldsymbol{x} - \boldsymbol{\mu}_* \parallel_2^2$ goes to zero, making the quantization of $\boldsymbol{x} - \boldsymbol{\mu}_*$ more accurate. Accordingly, the search window size $W$ can potentially be reduced to speed-up the search.

In the streaming case, M-LVQ also provides an enhanced flexibility to update the encoding. As vectors are assigned to local centers, any additions will only trigger a re-encoding of the database vectors that are assigned to the same center as the new vector. Thus, the centers can be updated as the stream is processed, avoiding any need to re-encode the entire database. This feature is also useful in the presence of large data distribution shifts, where the distribution drift is often local (e.g., when adding a new product class) and thus most centers can remain untouched.

M-LVQ stores $\lceil log_2 M \rceil$ bits for each vector to indicate which center was used to encode the vector in order to compute the similarity of the vector to the query. As LVQ-compressed vectors are padded to a multiple of thirty-two bytes to improve performance, the additional footprint in M-LVQ can be hidden in practice.

Updating the Multiple Means Over Time

M-LVQ improves the process of updating the encoded vectors dynamically over time. With M-LVQ, it is possible to update only the vectors corresponding to the centers that are shifting (e.g., bypassing/avoiding a re-encoding of the entire database).

Updating the means $\{\boldsymbol{\mu}_m\}_{m=1}^{M}$ and keeping the encoded vectors up-to-date can involve the following operations: 1. Compute the new means; 2. Identify which means changed significantly with respect to their previous values; 3. Update only those means that changed significantly; 4. Re-encode the vectors assigned to the clusters whose means were updated; and 5. Encode the added vectors.

*1. Compute new means*

For every batch of deleted vectors $X_{del}$ and added vectors $X_{add}$, compute the new means $\{\boldsymbol{\mu}_m^*\}_{m=1}^{M}$ by first removing the deleted vectors from their corresponding clusters, and then running mini-batch k-means to update the means with the new vectors in $X_{add}$.

*2. Identify which means changed significantly with respect to their previous values*

Find the shift that each centroid $\{\boldsymbol{\mu}_m\}_{m=1}^{M}$ underwent by computing the Euclidean distance between the old and new centroids $\beta_m = \parallel \boldsymbol{\mu_m} - \boldsymbol{\mu}_m^* \parallel_2^2 \ \forall \ m = 1, ..., M$. Then use the M distances to compute the histogram of the shifts. Use the histogram to compute the probability $p_m = prob(\beta \leq \beta_m)$ that a centroid shift is smaller or equal than the one observed for each $\boldsymbol{\mu_m}$. Those means $\boldsymbol{\mu_m}$ for which $p_m \geq p_{thres}$ ($p_{thres} = 0.9$) have shifted significantly and are updated. Otherwise, the means are left unchanged.

*3. Update only the means that changed significantly*

If $p_m \geq p_{thres}$, then set $\boldsymbol{\mu_m} = \boldsymbol{\mu}_m^*$

*4. Re-encode the vectors assigned to the clusters whose means were updated*

For all the vectors that belong to clusters whose means were updated, re-assign the vectors and update their encodings.

*5. Encode the added vectors*

Assign all vectors in $X_{add}$ to their corresponding clusters and compute the respective encodings.

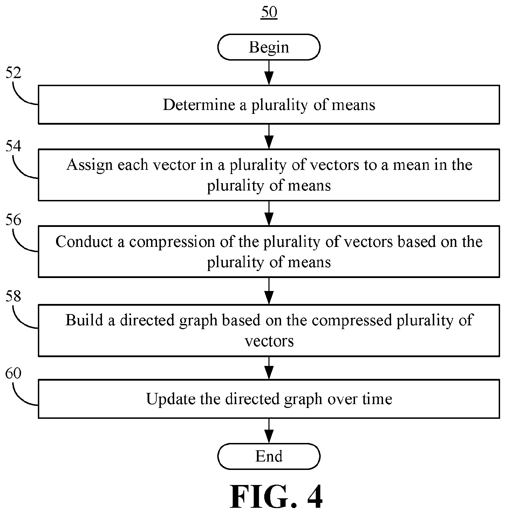

FIG. 4 shows a method 50 of managing a directed graph. The method 50 may be implemented in one or more modules as a set of logic instructions stored in a machine- or computer-readable storage medium such as random access memory (RAM), read only memory (ROM), programmable ROM (PROM), firmware, flash memory, etc., in hardware, or any combination thereof. For example, hardware implementations may include configurable logic, fixed-functionality logic, or any combination thereof. Examples of configurable logic (e.g., configurable hardware) include suitably configured programmable logic arrays (PLAs), field programmable gate arrays (FPGAs), complex programmable logic devices (CPLDs), and general purpose microprocessors. Examples of fixed-functionality logic (e.g., fixed-functionality hardware) include suitably configured application specific integrated circuits (ASICs), combinational logic circuits, and sequential logic circuits. The configurable or fixed-functionality logic can be implemented with complementary metal oxide semiconductor (CMOS) logic circuits, transistor-transistor logic (TTL) logic circuits, or other circuits.

Computer program code to carry out operations shown in the method 50 can be written in any combination of one or more programming languages, including an object-oriented programming language such as JAVA, SMALLTALK, C++ or the like and conventional procedural programming languages, such as the "C" programming language or similar programming languages. Additionally, logic instructions might include assembler instructions, instruction set architecture (ISA) instructions, machine instructions, machine dependent instructions, microcode, state-setting data, configuration data for integrated circuitry, state information that personalizes electronic circuitry and/or other structural components that are native to hardware (e.g., host processor, central processing unit/CPU, microcontroller, etc.).

Illustrated processing block 52 provides for determining a plurality of means (e.g., a set of means values based on a plurality of vectors). In one example, each mean in the plurality of means corresponds to a center of a cluster. Block 54 assigns each vector in the plurality of vectors to a mean in the plurality of means and block 56 conducts a compression of the plurality of vectors based on the plurality of means. In an embodiment, block 58 builds a directed graph based on the compressed plurality of vectors. In one example, block 58 also provides for conducting a search (e.g., streaming similarity search) of the directed graph based on a query. Additionally, block 60 may update the directed graph over time. The method 50 therefore enhances performance at least to the extent that using multiple means improves compression accuracy (e.g., in static cases). Indeed, the accuracy of the compressed plurality of vectors increases as the number of means in the plurality of means increases.

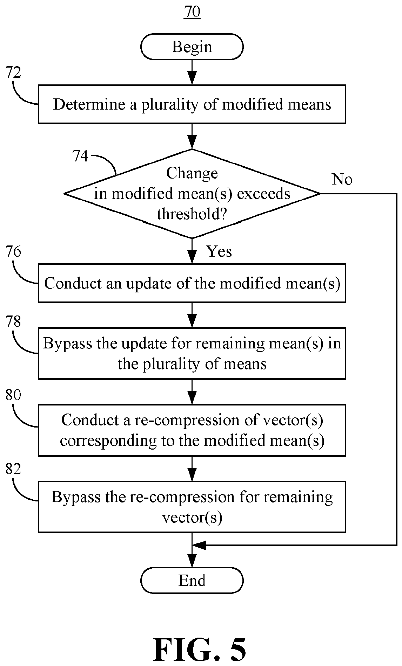

FIG. 5 shows a method 70 of updating a directed graph over time. The method 70 may generally be incorporated into the block 60 (FIG. 4), already discussed. More particularly, the method 70 may be implemented in one or more modules as a set of logic instructions stored in a machine- or computer-readable storage medium such as RAM, ROM, PROM, firmware, flash memory, etc., in hardware, or any combination thereof.

Illustrated processing block 72 provides for determining a plurality of modified means (e.g., a set of modified means values based on a plurality of vectors). A determination is made at block 74 as to whether a change in one or modified means in the plurality of modified means exceeds a threshold. If so, block 76 conducts an update of the one or more modified means. Additionally, block 78 bypasses the update for one or more remaining means in the plurality of modified means. In one example, block 80 conducts a re-compression of one or more vectors in the plurality of vectors corresponding to the one or more modified means. Block 82 bypasses the re-compression for one or more remaining vectors in the plurality of vectors. If it is determined at block 74 that no changes in the modified means exceed the threshold, the method 70 bypasses blocks 76, 78, 80 and 82, and terminates. The method 70 therefore further enhances performance at least to the extent that selectively bypassing the update and the re-compression speeds up the search (e.g., reduces latency in dynamic cases).

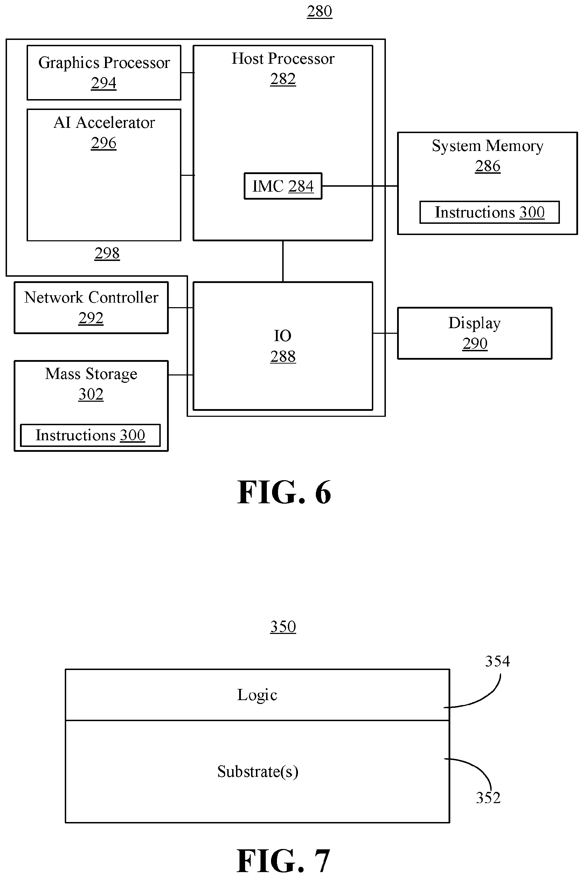

Turning now to FIG. 6, a performance-enhanced computing system 280 is shown. The system 280 may generally be part of an electronic device/platform having computing functionality (e.g., personal digital assistant/PDA, notebook computer, tablet computer, convertible tablet, edge node, server, cloud computing infrastructure), communications functionality (e.g., smart phone), imaging functionality (e.g., camera, camcorder), media playing functionality (e.g., smart television/TV), wearable functionality (e.g., watch, eyewear, headwear, footwear, jewelry), vehicular functionality (e.g., car, truck, motorcycle), robotic functionality (e.g., autonomous robot), Internet of Things (IoT) functionality, drone functionality, etc., or any combination thereof.

In the illustrated example, the system 280 includes a host processor 282 (e.g., central processing unit/CPU) having an integrated memory controller (IMC) 284 that is coupled to a system memory 286 (e.g., dual inline memory module/DIMM including dynamic RAM/DRAM). In an embodiment, an IO (input/output) module 288 is coupled to the host processor 282. The illustrated IO module 288 communicates with, for example, a display 290 (e.g., touch screen, liquid crystal display/LCD, light emitting diode/LED display), mass storage 302 (e.g., hard disk drive/HDD, optical disc, solid state drive/SSD) and a network controller 292 (e.g., wired and/or wireless). The host processor 282 may be combined with the IO module 288, a graphics processor 294, and an AI accelerator 296 (e.g., specialized processor) into a system on chip (SoC) 298.

In an embodiment, the AI accelerator 296 and/or the host processor 282 execute instructions 300 (e.g., executable program instructions) retrieved from the system memory 286 and/or the mass storage 302 to perform one or more aspects of the method 50 (FIG. 4) and/or the method 70 (FIG. 5), already discussed. Thus, execution of the instructions 300 causes the AI accelerator 296, the host processor 282 and/or the computing system 280 to determine a plurality of means, assign each vector in a plurality of vectors to a mean in the plurality of means, and conduct a compression of the plurality of vectors based on the plurality of means.

For example, the computing system 280 can use contextual data in variety of RAG settings. In consumer goods and retail applications, the computing system 280 might be deployed in virtual fitting rooms, delivery and installation environments, in-store product-finding assistance environments, demand prediction and inventory planning environments, novel product design environments, etc., to augment pre-trained models with proprietary data. In healthcare and medicine applications, the computing system 280 may be used to assist busy front-line staff, transcribe and summarize medical notes, answer medical questions as a chatbot, inform diagnosis and treatments via predictive analytics, etc., with organization-specific context data. In manufacturing environments, the computing system 280 can be deployed as an expert copilot for technicians, in conversational interactions with machines, in prescriptive and proactive field service, in natural language troubleshooting, in warranty status and documentation, in recovery strategy solutions (e.g., understanding process bottlenecks), and so forth.

In media and entertainment applications, the computing system 280 can be used to perform intelligent search and tailored content delivery, headline and copy development, provide real-time feedback on content quality, personalize playlists, news digests and recommendations, conduct interactive storytelling via viewer choices, make targeted offers and/or subscription plans, monitor network traffic to detect copyright infringement, etc. In financial services applications, the computing system 280 may be used to uncover trading signals, alert traders to vulnerable positions, accelerate underwriting decisions, optimize and rebuild legacy systems, reverse-engineer banking and insurance models, monitor for potential financial crimes and fraud, automate data gathering for regulatory compliance, extract insights from corporate disclosures, etc.

The computing system 280 is therefore considered performance-enhanced at least to the extent that using multiple means improves compression accuracy (e.g., in static cases). Indeed, the accuracy of the compressed plurality of vectors increases as the number of means in the plurality of means increases.

FIG. 7 shows a semiconductor apparatus 350 (e.g., chip, die, package). The illustrated apparatus 350 includes one or more substrates 352 (e.g., silicon, sapphire, gallium arsenide) and logic 354 (e.g., transistor array and other integrated circuit/IC components) coupled to the substrate(s) 352. In an embodiment, the logic 354 implements one or more aspects of the method 50 (FIG. 4) and/or the method 70 (FIG. 5), already discussed.

The logic 354 may be implemented at least partly in configurable or fixed-functionality hardware. In one example, the logic 354 includes transistor channel regions that are positioned (e.g., embedded) within the substrate(s) 352. Thus, the interface between the logic 354 and the substrate(s) 352 may not be an abrupt junction. The logic 354 may also be considered to include an epitaxial layer that is grown on an initial wafer of the substrate(s) 352.

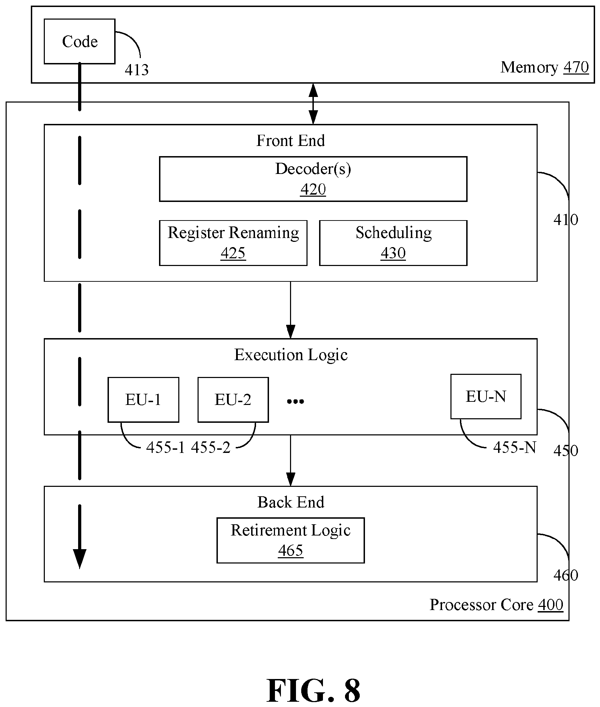

FIG. 8 illustrates a processor core 400 according to one embodiment. The processor core 400 may be the core for any type of processor, such as a micro-processor, an embedded processor, a digital signal processor (DSP), a network processor, or other device to execute code. Although only one processor core 400 is illustrated in FIG. 8, a processing element may alternatively include more than one of the processor core 400 illustrated in FIG. 8. The processor core 400 may be a single-threaded core or, for at least one embodiment, the processor core 400 may be multithreaded in that it may include more than one hardware thread context (or "logical processor") per core.

FIG. 8 also illustrates a memory 470 coupled to the processor core 400. The memory 470 may be any of a wide variety of memories (including various layers of memory hierarchy) as are known or otherwise available to those of skill in the art. The memory 470 may include one or more code 413 instruction(s) to be executed by the processor core 400, wherein the code 413 may implement the method 50 (FIG. 4) and/or the method 70 (FIG. 5), already discussed. The processor core 400 follows a program sequence of instructions indicated by the code 413. Each instruction may enter a front end portion 410 and be processed by one or more decoders 420. The decoder 420 may generate as its output a micro operation such as a fixed width micro operation in a predefined format, or may generate other instructions, microinstructions, or control signals which reflect the original code instruction. The illustrated front end portion 410 also includes register renaming logic 425 and scheduling logic 430, which generally allocate resources and queue the operation corresponding to the convert instruction for execution.

The processor core 400 is shown including execution logic 450 having a set of execution units 455-1 through 455-N. Some embodiments may include a number of execution units dedicated to specific functions or sets of functions. Other embodiments may include only one execution unit or one execution unit that can perform a particular function. The illustrated execution logic 450 performs the operations specified by code instructions.

After completion of execution of the operations specified by the code instructions, back end logic 460 retires the instructions of the code 413. In one embodiment, the processor core 400 allows out of order execution but requires in order retirement of instructions. Retirement logic 465 may take a variety of forms as known to those of skill in the art (e.g., reorder buffers or the like). In this manner, the processor core 400 is transformed during execution of the code 413, at least in terms of the output generated by the decoder, the hardware registers and tables utilized by the register renaming logic 425, and any registers (not shown) modified by the execution logic 450.

Although not illustrated in FIG. 8, a processing element may include other elements on chip with the processor core 400. For example, a processing element may include memory control logic along with the processor core 400. The processing element may include I/O control logic and/or may include I/O control logic integrated with memory control logic. The processing element may also include one or more caches.

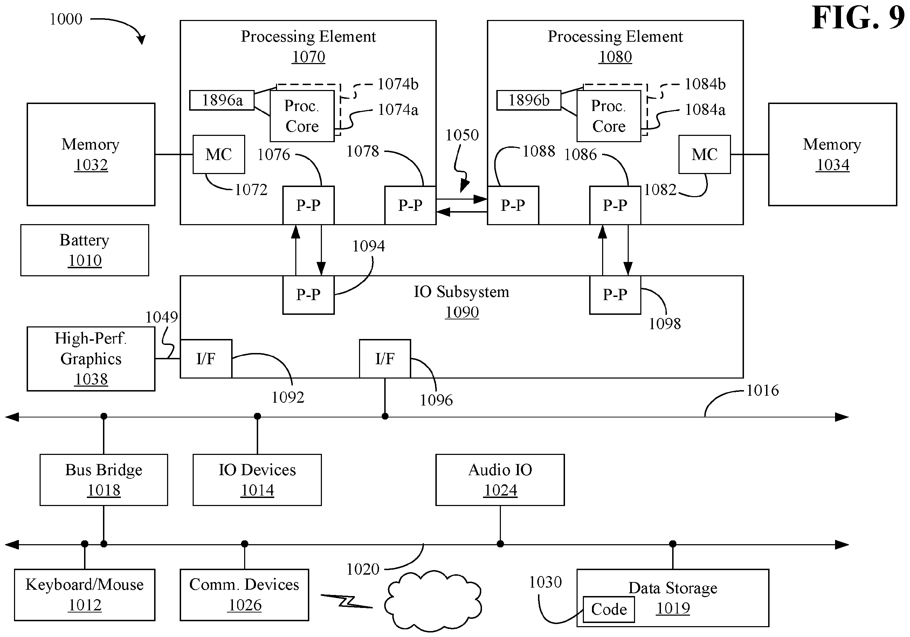

Referring now to FIG. 9, shown is a block diagram of a computing system 1000 embodiment in accordance with an embodiment. Shown in FIG. 9 is a multiprocessor system 1000 that includes a first processing element 1070 and a second processing element 1080. While two processing elements 1070 and 1080 are shown, it is to be understood that an embodiment of the system 1000 may also include only one such processing element.

The system 1000 is illustrated as a point-to-point interconnect system, wherein the first processing element 1070 and the second processing element 1080 are coupled via a point-to-point interconnect 1050. It should be understood that any or all of the interconnects illustrated in FIG. 9 may be implemented as a multi-drop bus rather than point-to-point interconnect.

As shown in FIG. 9, each of processing elements 1070 and 1080 may be multicore processors, including first and second processor cores (i.e., processor cores 1074a and 1074b and processor cores 1084a and 1084b). Such cores 1074a, 1074b, 1084a, 1084b may be configured to execute instruction code in a manner similar to that discussed above in connection with FIG. 8.

Each processing element 1070, 1080 may include at least one shared cache 1896a, 1896b. The shared cache 1896a, 1896b may store data (e.g., instructions) that are utilized by one or more components of the processor, such as the cores 1074a, 1074b and 1084a, 1084b, respectively. For example, the shared cache 1896a, 1896b may locally cache data stored in a memory 1032, 1034 for faster access by components of the processor. In one or more embodiments, the shared cache 1896a, 1896b may include one or more mid-level caches, such as level 2 (L2), level 3 (L3), level 4 (L4), or other levels of cache, a last level cache (LLC), and/or combinations thereof.

While shown with only two processing elements 1070, 1080, it is to be understood that the scope of the embodiments are not so limited. In other embodiments, one or more additional processing elements may be present in a given processor. Alternatively, one or more of processing elements 1070, 1080 may be an element other than a processor, such as an accelerator or a field programmable gate array. For example, additional processing element(s) may include additional processors(s) that are the same as a first processor 1070, additional processor(s) that are heterogeneous or asymmetric to processor a first processor 1070, accelerators (such as, e.g., graphics accelerators or digital signal processing (DSP) units), field programmable gate arrays, or any other processing element. There can be a variety of differences between the processing elements 1070, 1080 in terms of a spectrum of metrics of merit including architectural, micro architectural, thermal, power consumption characteristics, and the like. These differences may effectively manifest themselves as asymmetry and heterogeneity amongst the processing elements 1070, 1080. For at least one embodiment, the various processing elements 1070, 1080 may reside in the same die package.

The first processing element 1070 may further include memory controller logic (MC) 1072 and point-to-point (P-P) interfaces 1076 and 1078. Similarly, the second processing element 1080 may include a MC 1082 and P-P interfaces 1086 and 1088. As shown in FIG. 9, MC's 1072 and 1082 couple the processors to respective memories, namely a memory 1032 and a memory 1034, which may be portions of main memory locally attached to the respective processors. While the MC 1072 and 1082 is illustrated as integrated into the processing elements 1070, 1080, for alternative embodiments the MC logic may be discrete logic outside the processing elements 1070, 1080 rather than integrated therein.

The first processing element 1070 and the second processing element 1080 may be coupled to an I/O subsystem 1090 via P-P interconnects 1076 1086, respectively. As shown in FIG. 9, the I/O subsystem 1090 includes P-P interfaces 1094 and 1098. Furthermore, I/O subsystem 1090 includes an interface 1092 to couple I/O subsystem 1090 with a high performance graphics engine 1038. In one embodiment, bus 1049 may be used to couple the graphics engine 1038 to the I/O subsystem 1090. Alternately, a point-to-point interconnect may couple these components.

In turn, I/O subsystem 1090 may be coupled to a first bus 1016 via an interface 1096. In one embodiment, the first bus 1016 may be a Peripheral Component Interconnect (PCI) bus, or a bus such as a PCI Express bus or another third generation I/O interconnect bus, although the scope of the embodiments are not so limited.

As shown in FIG. 9, various I/O devices 1014 (e.g., biometric scanners, speakers, cameras, sensors) may be coupled to the first bus 1016, along with a bus bridge 1018 which may couple the first bus 1016 to a second bus 1020. In one embodiment, the second bus 1020 may be a low pin count (LPC) bus. Various devices may be coupled to the second bus 1020 including, for example, a keyboard/mouse 1012, communication device(s) 1026, and a data storage unit 1019 such as a disk drive or other mass storage device which may include code 1030, in one embodiment. The illustrated code 1030 may implement the method 50 (FIG. 4) and/or the method 70 (FIG. 5), already discussed. Further, an audio I/O 1024 may be coupled to second bus 1020 and a battery 1010 may supply power to the computing system 1000.

Note that other embodiments are contemplated. For example, instead of the point-to-point architecture of FIG. 9, a system may implement a multi-drop bus or another such communication topology. Also, the elements of FIG. 9 may alternatively be partitioned using more or fewer integrated chips than shown in FIG. 9.

In one example, the technology described herein is incorporated into the Scalable Vector Search (SVS) library from INTEL. SVS delivers fast vector search capabilities, optimizing retrieval times and improving overall system performance. Optimizing graph-based searches using M-LVQ as described herein reduces the memory footprint of vector databases and improves search throughput (e.g., QPS) at high accuracy, while being suited to efficient incremental updates (e.g., to reflect changes in the collection of vectors over time).

Indeed, the merits of M-LVQ in the context of the state-of-the-art graph search in SVS are significant for static and dynamic indexing. There may also be an advantage of SVS combined with M-LVQ over state-of-the-art streaming similarity search techniques. For the static indexing comparison, search performance speedup is achieved for image datasets and natural language processing (NLP) datasets. For example, the combination of improved compression accuracy and efficient management of the overhead incurred by having extra means provides positive results for image datasets.

For the comparison on streaming data, search performance speedup is achieved during the steady-state phase, where additions and deletions are performed while keeping the total number of vectors fixed. Moreover, SVS powered with M-LVQ exhibits a large search performance advantage over state-of-the-art streaming similarity search techniques that consistently holds over time. Even under data distribution shifts, SVS with M-LVQ outperforms other solutions at small and large scales

Additional Notes and Examples:

Example 1 includes a performance-enhanced computing system comprising a network controller, a processor coupled to the network controller, and a memory coupled to the processor, the memory including a plurality of executable program instructions, which when executed by the processor, cause the processor to determine a plurality of means based on a plurality of vectors, wherein each mean in the plurality of means is to correspond to center of a cluster, assign each vector in the plurality of vectors to a mean in the plurality of means, and conduct a compression of the plurality of vectors based on the plurality of means.

Example 2 includes the computing system of Example 1, wherein the instructions, when executed, further cause the processor to build a directed graph based on the compressed plurality of vectors, and update the directed graph.

Example 3 includes the computing system of Example 2, wherein to update the directed graph, the plurality of executable program instructions, when executed, further cause the processor to determine a plurality of modified means, detect that a change in one or more modified means in the plurality of modified means exceeds a threshold, conduct an update of the one or more modified means, and bypass the update for one or more remaining means in the plurality of modified means.

Example 4 includes the computing system of Example 3, wherein the plurality of executable program instructions, when executed, further cause the processor to conduct a re-compression of one or more vectors in the plurality of vectors corresponding to the one or more modified means, and bypass the re-compression for one or more remaining vectors in the plurality of vectors.

Example 5 includes the computing system of any one of Examples 2 to 4, wherein the plurality of executable program instructions, when executed, further cause the processor to conduct a similarity search of the directed graph based on a query.

Example 6 includes at least one computer readable storage medium comprising a plurality of executable program instructions, which when executed by a computing system, cause the computing system to determine a plurality of means based on a plurality of vectors, wherein each mean in the plurality of means is to correspond to a center of a cluster, assign each vector in the plurality of vectors to a mean in the plurality of means, and conduct a compression of the plurality of vectors based on the plurality of means.

Example 7 includes the at least one computer readable storage medium of Example 6, wherein the instructions, when executed, further cause the computer to build a directed graph based on the compressed plurality of vectors, and update the directed graph.

Example 8 includes the at least one computer readable storage medium of Example 7, wherein to update the directed graph, the plurality of executable program instructions, when executed, further cause the computing system to determine a plurality of modified means, detect that a change in one or more modified means in the plurality of modified means exceeds a threshold, conduct an update of the one or more modified means, and bypass the update for one or more remaining means in the plurality of modified means.

Example 9 includes the at least one computer readable storage medium of Example 8, wherein the plurality of executable program instructions, when executed, further cause the computing system to conduct a re-compression of one or more vectors in the plurality of vectors corresponding to the one or more modified means, and bypass the re-compression for one or more remaining vectors in the plurality of vectors.

Example 10 includes the at least one computer readable storage medium of Example 7, wherein the plurality of executable program instructions, when executed, further cause the computing system to conduct a search of the directed graph based on a query.

Example 11 includes the at least one computer readable storage medium of Example 10, wherein the search is a similarity search.

Example 12 includes the at least one computer readable storage medium of any one of Examples 6 to 11, wherein an accuracy of the compressed plurality of vectors increases as a number of means in the plurality of means increases.Example

Example 13 includes a semiconductor apparatus comprising one or more substrates, and logic coupled to the one or more substrates, wherein the logic is implemented at least partly in one or more of configurable or fixed-functionality hardware, the logic to determine a plurality of means based on a plurality of vectors, wherein each mean in the plurality of means is to correspond to a center of a cluster, assign each vector in th plurality of vectors to a mean in the plurality of means, and conduct a compression of the plurality of vectors based on the plurality of means.

Example 14 includes the semiconductor apparatus of Example 13, wherein the logic is further to build a directed graph based on the compressed plurality of vectors, and update the directed graph.

Example 15 includes the semiconductor apparatus of Example 14, wherein to update the directed graph, the logic is to determine a plurality of modified means, detect that a change in one or more modified means in the plurality of modified means exceeds a threshold, conduct an update of the one or more modified means, and bypass the update for one or more remaining means in the plurality of modified means.

Example 16 includes the semiconductor apparatus of Example 15, wherein the logic is further to conduct a re-compression of one or more vectors in the plurality of vectors corresponding to the one or more modified means, and bypass the re-compression for one or more remaining vectors in the plurality of vectors.

Example 17 includes the semiconductor apparatus of Example 14, wherein the logic is further to conduct a search of the directed graph based on a query.

Example 18 includes the semiconductor apparatus of Example 17, wherein the search is a similarity search.

Example 19 includes the semiconductor apparatus of any one of ExampleExamples 13 to 18, wherein an accuracy of the compressed plurality of vectors increases as a number of means in the plurality of means increases. Example

Example 20 includes the semiconductor apparatus of any one of Examples 13 to 19, wherein the logic coupled to the one or more substrates includes transistor regions that are positioned within the one or more substrates.

Example 21 includes a method of operating a performance-enhanced computing system, the method comprising determining a plurality of means, assigning each vector in a plurality of vectors to a mean in the plurality of means, and conducting a compression of the plurality of vectors based on the plurality of means.

Example 22 includes an apparatus comprising means for performing the method of Example 21.

Example sizes/models/values/ranges may have been given, although embodiments are not limited to the same. As manufacturing techniques (e.g., photolithography) mature over time, it is expected that devices of smaller size could be manufactured. In addition, well known power/ground connections to IC chips and other components may or may not be shown within the figures, for simplicity of illustration and discussion, and so as not to obscure certain aspects of the embodiments. Further, arrangements may be shown in block diagram form in order to avoid obscuring embodiments, and also in view of the fact that specifics with respect to implementation of such block diagram arrangements are highly dependent upon the computing system within which the embodiment is to be implemented, i.e., such specifics should be well within purview of one skilled in the art. Where specific details (e.g., circuits) are set forth in order to describe example embodiments, it should be apparent to one skilled in the art that embodiments can be practiced without, or with variation of, these specific details. The description is thus to be regarded as illustrative instead of limiting.

The term "coupled" may be used herein to refer to any type of relationship, direct or indirect, between the components in question, and may apply to electrical, mechanical, fluid, optical, electromagnetic, electromechanical or other connections. In addition, the terms "first", "second", etc. may be used herein only to facilitate discussion, and carry no particular temporal or chronological significance unless otherwise indicated.

As used in this application and in the claims, a list of items joined by the term "one or more of" may mean any combination of the listed terms. For example, the phrases "one or more of A, B or C" may mean A; B; C; A and B; A and C; B and C; or A, B and C.

Those skilled in the art will appreciate from the foregoing description that the broad techniques of the embodiments can be implemented in a variety of forms. Therefore, while the embodiments have been described in connection with particular examples thereof, the true scope of the embodiments should not be so limited since other modifications will become apparent to the skilled practitioner upon a study of the drawings, specification, and following claims.

**Claims**

1. A computing system comprising:

   a network controller;
   a processor coupled to the network controller; and
   a memory coupled to the processor, the memory including a plurality of executable program instructions, which when executed by the processor, cause the processor to:

      determine a plurality of means based on a plurality of vectors , wherein each mean in the plurality of means is to correspond to a center of a cluster,
      assign each vector in the plurality of vectors to a mean in the plurality of means, and
      conduct a compression of the plurality of vectors based on the plurality of means.

2. The computing system of claim 1, wherein the instructions, when executed, further cause the processor to:

   build a directed graph based on the compressed plurality of vectors, and
   update the directed graph.

3. The computing system of claim 2, wherein to update the directed graph, the plurality of executable program instructions, when executed, further cause the processor to:

   determine a plurality of modified means,
   detect that a change in one or more modified means in the plurality of modified means exceeds a threshold,
   conduct an update of the one or more modified means, and
   bypass the update for one or more remaining means in the plurality of modified means.

4. The computing system of claim 3, wherein the plurality of executable program instructions, when executed, further cause the processor to:

   conduct a re-compression of one or more vectors in the plurality of vectors corresponding to the one or more modified means, and
   bypass the re-compression for one or more remaining vectors in the plurality of vectors.

5. The computing system of any of claims 2-4, wherein the plurality of executable program instructions, when executed, further cause the processor to conduct a similarity search of the directed graph based on a query.

6. At least one computer readable storage medium comprising a plurality of executable program instructions, which when executed by a computing system, cause the computing system to:

   determine a plurality of means based on a plurality of vectors, wherein each mean in the plurality of means is to correspond to a center of a cluster;
   assign each vector in the plurality of vectors to a mean in the plurality of means; and
   conduct a compression of the plurality of vectors based on the plurality of means.

7. The at least one computer readable storage medium of claim 6, wherein the instructions, when executed, further cause the computer to:

   build a directed graph based on the compressed plurality of vectors; and
   update the directed graph.

8. The at least one computer readable storage medium of claim 7, wherein to update the directed graph, the plurality of executable program instructions, when executed, further cause the computing system to:

   determine a plurality of modified means;
   detect that a change in one or more modified means in the plurality of modified means exceeds a threshold;
   conduct an update of the one or more modified means; and
   bypass the update for one or more remaining means in the plurality of modified means.

9. The at least one computer readable storage medium of claim 8, wherein the plurality of executable program instructions, when executed, further cause the computing system to:

   conduct a re-compression of one or more vectors in the plurality of vectors corresponding to the one or more modified means; and
   bypass the re-compression for one or more remaining vectors in the plurality of vectors.

10. The at least one computer readable storage medium of any of claims 7-9, wherein the plurality of executable program instructions, when executed, further cause the computing system to conduct a similarity search of the directed graph based on a query, and wherein an accuracy of the compressed plurality of vectors increases as a number of means in the plurality of means increases.

11. A semiconductor apparatus comprising:

   one or more substrates; and
   logic coupled to the one or more substrates, wherein the logic is implemented at least partly in one or more of configurable or fixed-functionality hardware, the logic to:

      determine a plurality of means based on a plurality of vectors, wherein each mean in the plurality of means is to correspond to a center of a cluster;
      assign each vector in the plurality of vectors to a mean in the plurality of means; and
      conduct a compression of the plurality of vectors based on the plurality of means.

12. The semiconductor apparatus of claim 11, wherein the logic is further to:

   build a directed graph based on the compressed plurality of vectors; and
   update the directed graph.

13. The semiconductor apparatus of claim 12, wherein to update the directed graph, the logic is to:

   determine a plurality of modified means;
   detect that a change in one or more modified means in the plurality of modified means exceeds a threshold;
   conduct an update of the one or more modified means; and
   bypass the update for one or more remaining means in the plurality of modified means.

14. The semiconductor apparatus of claim 13, wherein the logic is further to:

   conduct a re-compression of one or more vectors in the plurality of vectors corresponding to the one or more modified means; and
   bypass the re-compression for one or more remaining vectors in the plurality of vectors.

15. The semiconductor apparatus of any of claims 12-14, wherein the logic is further to conduct a similarity search of the directed graph based on a query, and wherein an accuracy of the compressed plurality of vectors increases as a number of means in the plurality of means increases.

Ask — Prompt + Retrieved Context — Generate Answer

24 — 24a — User Prompt

24b — Retrieval Mechanisms

24c — Pre-Trained LLM

24d — Generated Response based on Retrieved Context + User Prompt

20

Vector Search (M-LVQ)

Relevant Context Retrieved

Private Knowledge (Vector Database)

22

**FIG. 1**

<u>30</u>

**Inputs:** graph $G = (\mathcal{V}, \mathcal{E})$, query **q**, number of neighbors $k \in \mathbb{N}$,
priority queue capacity $W \geq k$, initial candidates $S \subset \mathcal{V}$,
similarity function sim

**Result:** $k$ approximate nearest neighbors to **q** in $G$

$Q = S$ // Initialize candidate set $Q$.

// Initially, no nodes are marked as explored.

**while** *there exists an unexplored node in $Q$* **do**

    **x** = closest unexplored node to **q** in $Q$ w.r.t. sim

    Mark **x** as explored

    **for** $\mathbf{x}' \in \mathcal{N}(\mathbf{x})$ **do** $Q \leftarrow Q \cup \mathbf{x}'$

    // Limit the size of $Q$ to at most $W$:

    $Q$ = the (at most) $W$ closest nodes to **q** in $Q$ w.r.t sim

**return** $k$ *nearest nodes to* **q** *in $Q$* w.r.t. sim

# FIG. 2

<u>40</u>

**Definition 1.** *Let* $\{\boldsymbol{\mu}_m \in \mathbb{R}^d\}_{m=1}^M$ *be a collection of M centers. We define the multi-means LVQ compression (M-LVQ-$B_1$x$B_2$) of vector* **x**, *respectively with $B_1$ and $B_2$ bits for the first and second levels, as the pair of vectors $Q(\mathbf{x})$ and $Q_{res}(\mathbf{r})$ such that*

- $Q(\mathbf{x}) = Q_{B_1, \ell(x), u(x)} (\mathbf{x} - \boldsymbol{\mu}_*)$ *with* $\boldsymbol{\mu}_* = \underset{m=1,\ldots,M}{\operatorname{argmin}} \|\mathbf{x} - \boldsymbol{\mu}_m\|_2^2,$
- $Q_{res}(\mathbf{r}) = Q_{B_2, -\Delta/2, \Delta/2}(\mathbf{r})$ *for* $\mathbf{r} = \mathbf{x} - \boldsymbol{\mu}_* - Q(\mathbf{x}),$

*where the scalar quantization function in Equation (2) is applied component-wise.*

# FIG. 3

<u>50</u>

Begin

52

Determine a plurality of means

54

Assign each vector in a plurality of vectors to a mean in the plurality of means

56

Conduct a compression of the plurality of vectors based on the plurality of means

58

Build a directed graph based on the compressed plurality of vectors

60

Update the directed graph over time

End

# FIG. 4

<u>70</u>

( Begin )

72 → Determine a plurality of modified means

74 → Change in modified mean(s) exceeds threshold? — No

Yes

76 → Conduct an update of the modified mean(s)

78 → Bypass the update for remaining mean(s) in the plurality of means

80 → Conduct a re-compression of vector(s) corresponding to the modified mean(s)

82 → Bypass the re-compression for remaining vector(s)

( End )

# FIG. 5

280

| | Host Processor 282 | |
|---|---|---|
| Graphics Processor 294 | | |
| AI Accelerator 296 | IMC 284 | System Memory 286 / Instructions 300 |

298

Network Controller 292

Mass Storage 302 / Instructions 300

IO 288

Display 290

## FIG. 6

350

354

Logic

Substrate(s)

352

## FIG. 7

**FIG. 8**

**FIG. 9**

**EUROPEAN SEARCH REPORT**

Europäisches Patentamt
European Patent Office
Office européen des brevets

**Application Number**

EP 25 15 8108

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Aguerrebere Cecilia ET AL: "Locally-Adaptive Quantization for Streaming Vector Search", arXiv.org, 3 February 2024 (2024-02-03), pages 1-23, XP093280247, Retrieved from the Internet: URL:https://arxiv.org/pdf/2402.02044 [retrieved on 2025-07-06] * par. System Setup; page 6, column 1, paragraph 4 * * sec. 3.2; page 4, column 1, line 7, paragraph 1 - line 10 * * Definition 1; page 4, column 1 * * section 2.2; page 2, column 2, line 1, paragraph 3 - line 2 * * section 3.2; page 4, column 1, line 1, paragraph 5 - line 3 * | 1-15 | INV. G06F16/901 G06F17/10 G06N20/00 H03M7/30 |

- - - - -

**TECHNICAL FIELDS SEARCHED (IPC)**

G06F
G06N
H03M

The present search report has been drawn up for all claims

| Place of search | Date of completion of the search | Examiner |
|---|---|---|
| The Hague | 1 September 2025 | Karaliolios, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 629 103 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63565748